# EUROPEAN PATENT SPECIFICATION

(11) **EP 0 400 873 B1**
(45) Date of publication and mention of the grant of the patent: **02.11.1994**
(21) Application number: 90305578.8
(22) Date of filing: 22.05.1990
(51) Int. Cl.: C23G 5/04, C23G 5/02

(54) **Method and apparatus for cleaning object**
Verfahren und Vorrichtung zur Reinigung von Gegenständen
Procédé et appareil pour le nettoyage d'objets

(30) Priority: 29.05.1989 JP 135461/89
(43) Date of publication of application: 05.12.1990
(73) Proprietor: JAPAN FIELD COMPANY, LTD., Nakano-ku Tokyo (JP)
(72) Inventor: Uchino, Masahide, c/o Japan Field Company Ltd., Tokyo (JP)
(74) Representative: Keltie, David Arthur

(56) References cited:
- EP-A- 0 069 096
- EP-A- 0 235 744

## Description

### 1. Field of the Invention

The present invention relates to a method and an apparatus for cleaning objects such as electronic parts, machine parts, and medical instruments, and is particularly useful in the case using as a cleaning fluid a solvent harmful to the human body, environment, etc. or a solvent that is highly combustible and is accompanied by a risk in use.

### 2. Description of the Prior Art

Conventionally, to clean electronic parts, machine parts, medical instruments, etc., solvents such as freon and trichloroethylene that influence detrimentally the human body, environment, etc. are used in many cases as cleaning fluid for cleaning the objects. However, these solvents are not completely freed from a problem that the solvents leak outside of the cleaning apparatus. Therefore, as solvent that influences less detrimentally the human body, environment, etc. alcohols such as isopropyl alcohol, terpenes, hydrocarbon solvents, and other combustible solvents are considered to be used.

However, since these are highly flammable, the use thereof is attended with a higher risk, and they are difficult to use. Particularly, these combustible solvents are high in such a risk that when the solvent gas leaks outside the apparatus, it catches fire from sparks or static electricity produced by the outer equipment. There are apparatuses that are developed to eliminate such a risk, but the apparatuses have complicated mechanisms, which make them expensive, and practically the use is difficult.

### SUMMARY OF THE INVENTION

The present invention intends to solve the above-mentioned problems, and the object of the present invention is to make it possible cleaning that secures high safety while using as a cleaning fluid, alcohols such as isopropyl alcohol, hydrocarbon solvents, terpenes, or other combustible solvents, and to prevent positively the diffusion of the solvent into the atmosphere even when solvents that are harmful to the human body, environment, etc. such as freon and trichloroethylene are used.

Specifically, in order to solve the above-mentioned problems, the present invention is to provide a method and apparatus for cleaning, characterized in that a cleaning means containing a solvent as a cleaning fluid is positioned in a holding tank holding an incombustible liquid, and is operated in the holding tank to clean an object.

The above object and other objects, advantages, features, and application of the present invention will become more apparent from the following description and the attached drawings.

### BRIEF DESCRIPTION OF THE DRAWINGS

Fig. 1 is a cross-sectional view showing the state of liquid cleaning of an object.

Fig. 2 is a cross-sectional view showing the state of vapor cleaning.

Fig. 3 is a cross-sectional view showing the state where an object is brought in and out.

Fig. 4 is a cross-sectional view showing the waiting state after the completion of cleaning operation.

Fig 5 is a cross-sectional view showing the state wherein part of the cleaning means is projected from a surface of incombustible liquid.

Fig. 6 is a cross-sectional view taken along line A-A of Fig 5, showing the state where the lid is opened.

Fig. 7 is a cross-sectional showing the state wherein the cleaning means is positioned over a surface of incombustible liquid.

### DESCRIPTION OF THE PREFERRED EMBODIMENTS

The present invention will now be described with reference to the drawings. Reference numeral (1) indicates a holding tank holding an incombustible liquid(2) such as water, an incombustible oil and the like, and a cleaning means (4) for cleaning an object (3) is submerged in the holding tank (1). If the cleaning means (4) keeps the liquid-tightness not to allow the incombustible liquid (2) to enter the inside when the cleaning means (4) is placed in the incombustible liquid (2), the constitution of the cleaning means (4) for the object (3) is not particularly limited, and for the cleaning means (4), any structure meeting the cleaning purpose can be chosen.

As shown in the figure, in the embodiment, a cleaning tank (6) where the object (3) introduced through a gateway (5) will be cleaned is placed in a position to be submerged in the incombustible liquid (2) of the holding tank (1), the cleaning tank (6) and a solvent liquid-filled tank (8) filled with a solvent liquid (7) are connected through a lead-out pump (10) and a filtering mechanism (11) so that the solvent liquid (7) can be transferred from the cleaning tank (6) to the solvent liquid-filled tank (8), the cleaning tank (6) and the solvent liquid-filled tank (8) filled with the solvent liquid (7) are also connected through a lead-in pump (12) so that the solvent liquid (7) can be transferred from the solvent liquid filled-tank (8) to the cleaning tank (6), and the cleaning tank (6) is connected to a vapor generating tank (14) through an on-off valve (13). The vapor generating tank (14) is provided with an inside lid (15) that can be pushed and opened with the increase of the vapor pressure and is positioned between a vapor generating section (16) and a condensing chamber (17), and the condensing chamber (17) has a cooling pipe (18) for condensing the vapor. The condensate produced in the condensing chamber (17) is led in the cleaning tank (6) through a lead-out pipe (20), and a cooling pipe (21) for condensation is provided near the gateway (5) in the cleaning tank (6) so that the condensate is led in the solvent liquid-filled tank (8) through a lead-out pipe (22). The solvent liquid-filled tank (8) and the vapor generating tank (14) are connected through a supply pipe (23) of the solvent liquid (7).

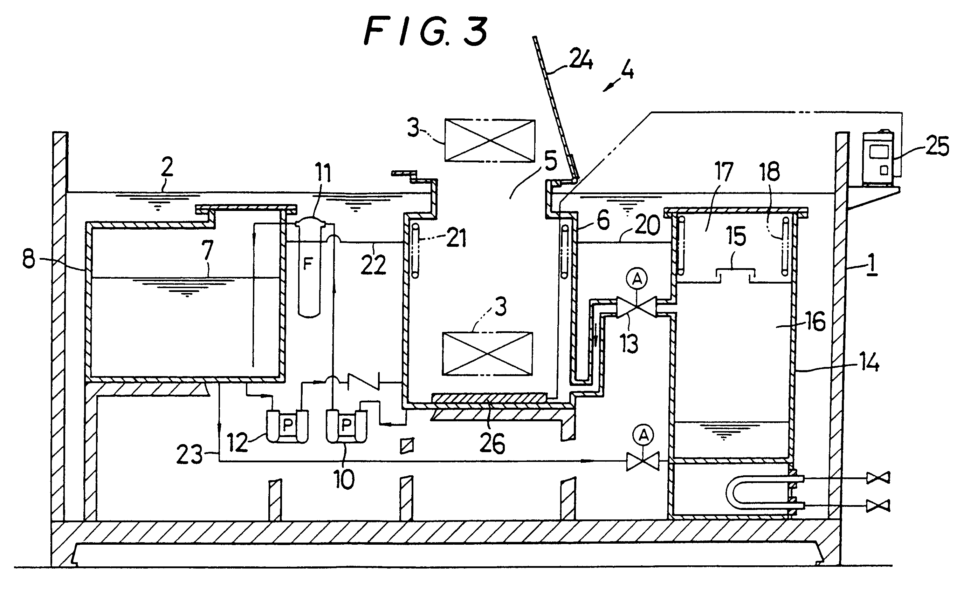

In order to carry out cleaning of the object (3) by the above arrangement, as shown in Fig. 3, the incombustible liquid (2) is removed from the holding tank (1) until the gateway (5) of the cleaning tank (6) is projected outside with the vapor generating tank (14) and the solvent liquid-filled tank (8) submerged, and then the gateway (5) of the cleaning tank (6) is opened to introduce the object (3). "Removal" or "pouring (described later)" of the incombustible liquid (2) is carried out by a known means including a pipe, a valve, a controlling tank, etc. (not shown).

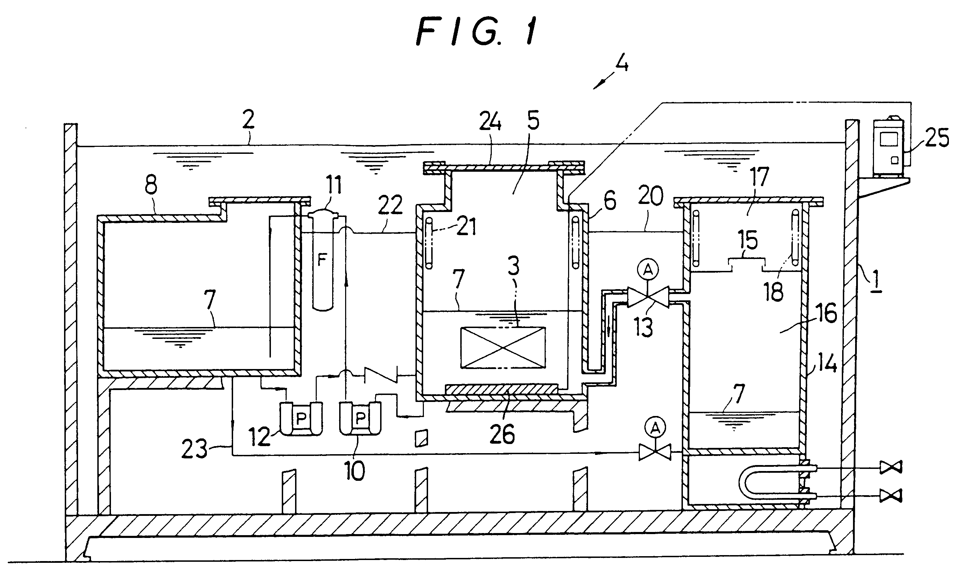

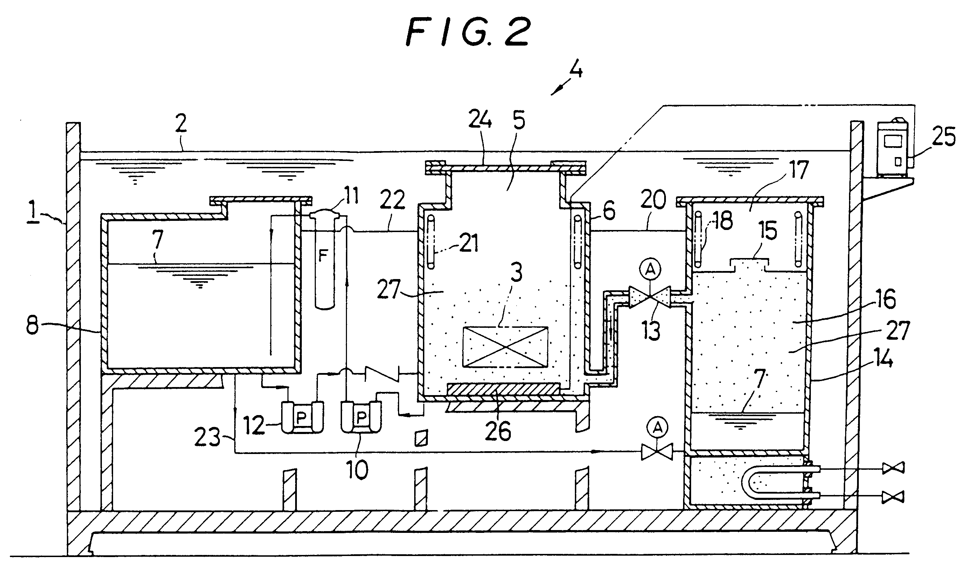

Then, a lid body (24) for opening or closing the gateway (5) of the cleaning tank (6) is closed, then as shown in Fig. 1, the incombustible liquid (2) is poured in the holding tank (1) until the gateway (5) is submerged, the solvent liquid (7) is loaded from the solvent liquid-filled tank (8) in the cleaning tank (6), and for example ultrasonic cleaning is effected by an ultrasonic vibrator (26) connected to an ultrasonic oscilator (25). After the completion of the liquid cleaning, as shown in Fig. 2, the solvent liquid (7) in the cleaning tank (6) is removed and is transferred to the solvent liquid-filled tank (8), the on-off valve (13) is released, and the cleaning vapor (27) is introduced into the cleaning tank (6) to carry out vapor cleaning. Of course, the vapor cleaning may be carried out without preceding liquid cleaning.

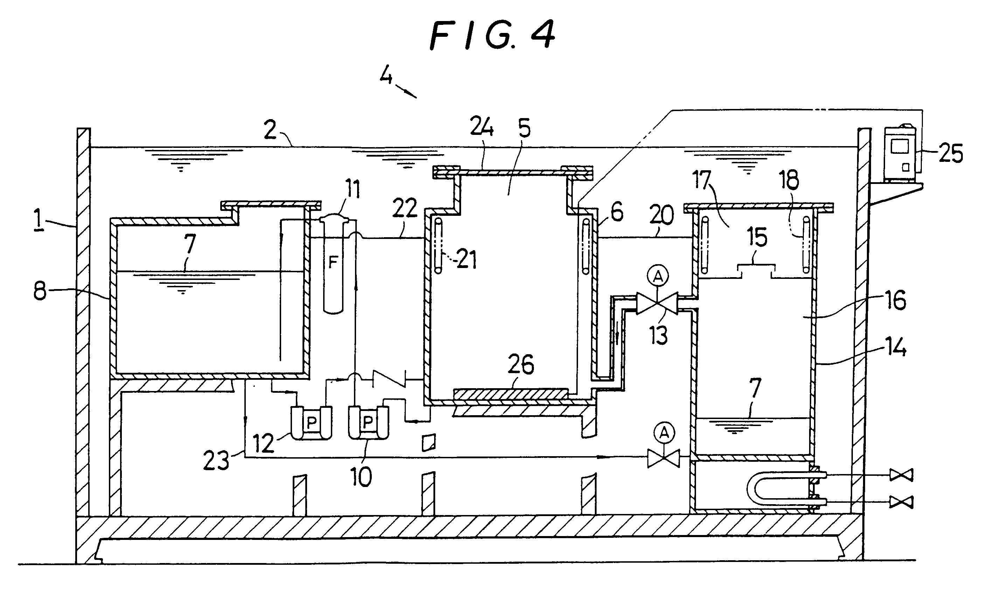

After the completion of the vapor cleaning, as shown in Fig. 3, the incombustible liquid (2) is removed from the holding tank (1) until the gateway (5) of the cleaning tank (6) is projected outside with the vapor generating tank (14) and the solvent liquid-filled tank (8) submerged, then the gateway (5) of the cleaning tank (6) is opened, and the object (3) is taken out. After the completion of the cleaning operation, as shown in Fig. 4, the holding tank (1) is filled with the incombustible liquid (2) until the cleaning tank (6), the vapor generating tank (14), and the solvent liquid-filled (8) are submerged, and they are allowed to wait for the next cleaning operation.

As described above, since the cleaning means (4) is positioned in the incombustible liquid (2), and the cleaning means (4) is operated in the incombustible liquid (2) to clean the object (3), even if a solvent that influences detrimentally the human body, environment, etc. a combustible solvent or the like is used as a cleaning liquid and the solvent gas leaks outside of the cleaning means, the leaked solvent gas is dissolved in or separated and held by the incombustible liquid (2), causing no risk of catching fire thereby allowing cleaning that secures high safety, and even if combustion occurs in the cleaning means (4), the spread of the risk to the outside can be minimized since the cleaning means (4) is situated in the incombustible liquid (2).

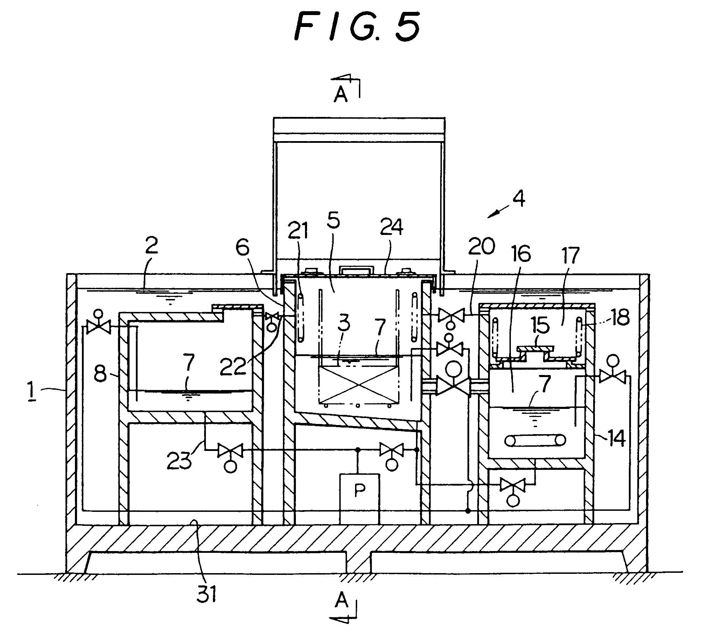

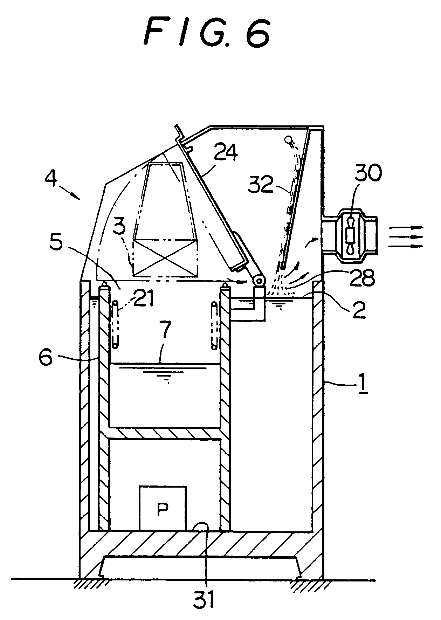

In the above embodiment, although the cleaning means (4) is submerged in the incombustible liquid (2) to allow high safety to be secured, in another embodiment as shown in Fig 5, the gateway (5) positioned upward of the cleaning tank (6) constituting the cleaning means (4), etc. is extended from the incombustible liquid (2), is positioned in the holding tank (1), and is not submerged. By thus constituting, the object (3) can be introduced or removed easily through the gateway (5) without removing part of the incombustible liquid (2), and even if the solvent gas or solvent liquid (7) leaks from sections where pipelines and the like are connected and the incombustible liquid (2) is in contact, the incombustible liquid (2) is in contact with the solvent gas and the solvent liquid (7) in the same way as above, causing no risk of catching fire, so that the safety of the cleaning operation can be increased remarkably. In this case, in order to prevent the solvent gas from diffusing at the time when the lid body (24) covering the gateway (5) is opened, as shown in Fig. 6, a communication port (28) is provided to the back of the gateway (5), and is directed to a suction fun (30) through a cooling liquid curtain (32) that will become in contact with the solvent gas to condense it thereby preventing the solvent gas leaking from the gateway (5) from diffusing.

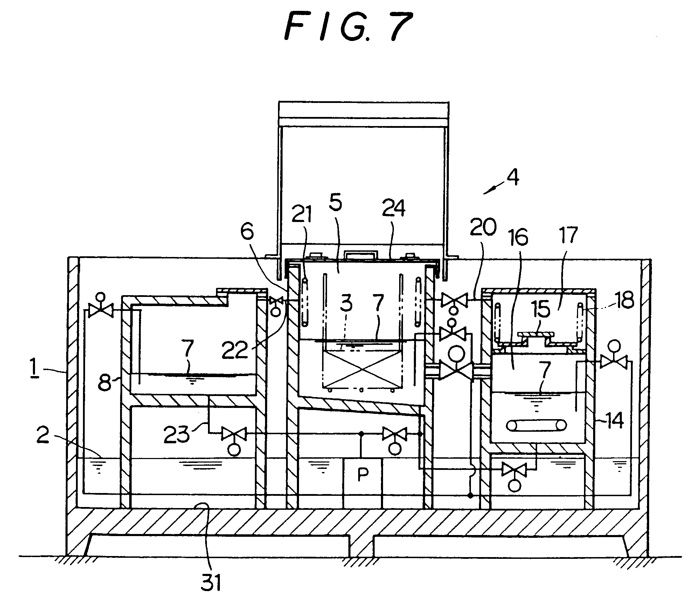

In the above embodiments, although the cleaning means (4) is allowed to be in direct contact with the incombustible liquid (2), in another different embodiment, as shown in Fig. 7, the incombustible liquid (2) is held only in the bottom (31) of the holding tank (1) without allowing the cleaning means (4) to be in direct contact with the incombustible liquid (2), and the cleaning means (4) is positioned over the surface of the incombustible liquid (2) whose amount is relatively small. In this case, the solvent liquid (7) leaked from the cleaning means (4) drops into the incombustible liquid (2), and becomes incombustible, and the solvent gas, if it has a specific gravity larger than that of air, stays in the holding tank (1) holding the cleaning means (4), and does not leak outside, so that the safety of the cleaning operation can be increased.

Even if a solvent that influences detrimentally the human body, environment, etc. such as freon and trichloroethylene is used as a cleaning liquid, when the solvent liquid (7) has a specific gravity greater than that of the incombustible liquid (2) such as water, the solvent leaked from the cleaning means (4) settles in the bottom (31) of the holding tank (1) holding the incombustible liquid (2), so that not only fear of the diffusion to the outside is obviated, but also the recovery of the solvent can be easily effected by using a moisture separating apparatus.

In the case wherein a terpene oil, a hydrocarbon solvent, or the like that has a specific gravity lower than that of the incombustible liquid (2) such as water and does not dissolve in water is used as the solvent liquid (7), when a surface active agent is mixed with the winter to allow the solvent (7) used for cleaning the object (3) to dissolve, the solvent does not float on the surface of the incombustible liquid (2) to allow the solvent gas to diffuse even if the solvent has a specific gravity lower than that of the incombustible liquid (2), so that it is enough to cope with the leakage of the solvent liquid (7).

As described above, in the present invention, since a cleaning means holding a solvent as a cleaning liquid is positioned in a holing tank holding an incombustible liquid and is operated in the holding tank to carry out cleaning of an object, even if an alcohol such as isopropyl alcohol, a terpene oil, a hydrocarbon oil, or other combustible solvent is used as a cleaning liquid and the solvent gas or the solvent liquid leaks outside from the cleaning means, the leaked combustible solvent gas or solvent liquid comes in contact with the incombustible liquid such as water, so that the risk of catching fire can be lowered, and cleaning with safety secured can be made..

Further, if the cleaning means is submerged in the incombustible liquid, and when an alcohol such as isopropyl alcohol, a terpene oil, a hydrocarbon oil, or other combustible solvent is used as a cleaning liquid and the solvent gas or the solvent liquid leaks outside from the cleaning means, the leaked combustible solvent gas or solvent liquid comes in contact with the incombustible liquid 100 % of which is water or the like, so that the risk of catching fire does not arise at all, and higher safety can be secured. When this submerged system is used, if combustion occurs in the cleaning means, its risk to spread outside can be minimized since the cleaning means is positioned in the incombustible liquid. Further, after the completion of the cleaning operation, if the cleaning means is submerged in the incombustible liquid, any special safety mechanism is not required, and it can be safely kept and controlled.

If part of the upper sections of the cleaning tank, etc. constituting the cleaning means is extended from the noncombustible liquid, and is placed in the holding tank with the part nosubmerged, the object to be cleaned can easily be introduced or taken out, and if the solvent leaks from sections where pipelines and the like are connected and the incombustible liquid (2) is in contact, since the incombustible liquid comes in contact with the solvent gas and solvent liquid similarly to the above so that there is no risk of catching fire, and the safety of cleaning operation can be increased remarkably.

When the cleaning means is not in direct contact with the incombustible liquid and is placed over the surface of the incombustible liquid held in the bottom of the holding tank, the solvent liquid leaked from the cleaning means drops into the incombustible liquid and becomes incombustible, and if the solvent gas has a specific gravity higher than that of air, it stays in the holding tank holding the cleaning means, so that it does not leak outside, and the safety of the cleaning operation can be increased.

Further, if a solvent that influences detrimentally the human body, environment, etc. such as freon and trichloroethylene is used, and the solvent has a specific gravity higher than that of the incombustible liquid such as water, the solvent leaked from the cleaning means settles in the bottom of the holding tank holding the incombustible liquid, so that not only there is no fear of the dispersion to the outside, but also the solvent can be recovered easily by using a moisture separating apparatus.

If a terpene oil, a hydrocarbon solvent, or the like that has a specific gravity lower than that of the incombustible liquid such as water and that does not dissolve in water is used, a surface active agent is mixed so as to dissolve the solvent for cleaning the object to be cleaned, and then if a solvent having a specific gravity lower than that of the incombustible liquid is used, the leaked solvent is allowed to dissolve in the incombustible liquid and is made incombustible, thereby preventing the risk of catching fire.

## Claims

1. A method of cleaning an object by using a solvent as a cleaning liquid, characterized in that a cleaning means holding a cleaning liquid is positioned in a holding tank holding an incombustible liquid and is operated in the holding tank.

2. A method of cleaning an object as claimed in claim 1, characterized in that the cleaning means is submerged in the incombustible liquid.

3. A method of cleaning an object as claimed in claim 1, characterized in that the cleaning means is placed in the holding tank with part of the upper end of the cleaning means extended from the incombustible liquid so that it is nonsubmerged.

4. A method of cleaning an object as claimed in claim 1, characterized in that the cleaning means is not in direct contact with the incombustible liquid and is positioned over the surface of the incombustible liquid held in the bottom of the holding tank.

5. A method of cleaning an object as claimed in any one of claims 1, 2, 3, and 4, characterized in that the incombustible liquid is water.

6. A method of cleaning an object as claimed in any one of claims 1, 2, 3, and 4, characterized in that the incombustible liquid is water with which a surface active agent is mixed so that the solvent for cleaning the object can be dissolved therein.

7. A method of cleaning an object as claimed in claim 1, characterized in that the solvent liquid for cleaning the object is a combustible solvent.

8. An apparatus for cleaning an object by using a solvent as a cleaning liquid, characterized in that the apparatus comprises a holding tank for holding an incombustible liquid and a cleaning means for cleaning the object that holds the cleaning liquid and is placed in the holding tank.

9. An apparatus of cleaning an object as claimed in claim 8, characterized in that the cleaning means is submerged in the incombustible liquid.

10. An apparatus for cleaning an object as claimed in claim 8, characterized in that the cleaning means is placed in the holding tank with part of the upper end of the cleaning means extended from the incombustible liquid so that it is nonsubmerged.

11. An apparatus for cleaning an object as claimed in claim 8, characterized in that the cleaning means is not in direct contact with the incombustible liquid and is positioned over the surface of the incombustible liquid held in the bottom of the holding tank.

12. An apparatus for cleaning an object as claimed in any one of claims 8, 9, 10, and 11, characterized in that the incombustible liquid is water.

13. An apparatus for cleaning an object as claimed in any one of claims 8, 9, 10 and 11, characterized in that the incombustible liquid is water with which a surface active agent is mixed so that the solvent for cleaning the object can be dissolved therein.

14. An apparatus for cleaning an object as claimed in claim 8, characterized in that the solvent liquid for cleaning the object is a combustible solvent.

## Patentansprüche

1. Verfahren zur Reinigung eines Gegenstandes mit Hilfe eines Lösungsmittels als Reinigungsflüssigkeit, dadurch gekennzeichnet, daß sich eine Reinigungsvorrichtung mit einer Reinigungsflüssigkeit in einem eine nicht brennbare Flüssigkeit enthaltenden Aufnahmebehälter befindet und in dem Aufnahmebehälter betrieben wird.

2. Verfahren zur Reinigung eines Gegenstandes nach Anspruch 1, dadurch gekennzeichnet, daß die Reinigungsvorrichtung in die nicht brennbare Flüssigkeit eingetaucht ist.

3. Verfahren zur Reinigung eines Gegenstandes nach Anspruch 1, dadurch gekennzeichnet, daß sich die Reinigungsvorrichtung in dem Aufnahmebehälter befindet, wobei ein Teil des oberen Endes der Reinigungsvorrichtung aus der nicht brennbaren Flüssigkeit so heraussteht, daß er nicht eingetaucht ist.

4. Verfahren zur Reinigung eines Gegenstandes nach Anspruch 1, dadurch gekennzeichnet, daß die Reinigungsvorrichtung nicht in direktem Kontakt mit der nicht brennbaren Flüssigkeit steht und oberhalb der nicht brennbaren Flüssigkeit vorgesehen ist, die sich im Bodenbereich des Aufnahmebehälters befindet.

5. Verfahren zur Reinigung eines Gegenstandes nach einem der Ansprüche 1, 2, 3 oder 4, dadurch gekennzeichnet, daß die nicht brennbare Flüssigkeit Wasser ist.

6. Verfahren zur Reinigung eines Gegenstandes nach einem der Ansprüche 1, 2, 3 oder 4, dadurch gekennzeichnet, daß die nicht brennbare Flüssigkeit Wasser ist, dem eine oberflächenaktive Substanz beigegeben wird, so daß das Lösungsmittel zum Reinigen des Gegenstandes darin gelöst wird.

7. Verfahren zur Reinigung eines Gegenstandes nach Anspruch 1, dadurch gekennzeichnet, daß die lösungsmittelhaltige Flüssigkeit zur Reinigung eines Gegenstandes ein brennbares Lösungsmittel ist.

8. Vorrichtung zur Reinigung eines Gegenstandes durch Verwendung eines Lösungsmittels als Reinigungsflüssigkeit, dadurch gekennzeichnet, daß die Vorrichtung einen Aufnahmebehälter zur Aufnahme einer nicht brennbaren Flüssigkeit und eine Reinigungsvorrichtung zur Reinigung des Gegenstandes aufweist, die die Reinigungsflüssigkeit aufnimmt und in dem Aufnahmebehälter angeordnet ist.

9. Vorrichtung zur Reinigung eines Gegenstandes nach Anspruch 8, dadurch gekennzeichnet, daß die Reinigungsvorrichtung in die nicht brennbare Flüssigkeit eingetaucht ist.

10. Vorrichtung zur Reinigung eines Gegenstandes nach Anspruch 8, dadurch gekennzeichnet, daß die Reinigungsvorrichtung in dem Aufnahmebehälter angeordnet ist, wobei ein Teil des oberen Endes der Reinigungsvorrichtung aus der nicht brennbaren Flüssigkeit herausragt, so daß er nicht eingetaucht ist.

11. Vorrichtung zur Reinigung eines Gegenstandes nach Anspruch 8, dadurch gekennzeichnet, daß die Reinigungsvorrichtung nicht in einem direkten Kontakt mit der nicht brennbaren Flüssigkeit steht und oberhalb nicht brennbaren Flüssigkeit angeordnet ist, die sich im Bodenbereich des Aufnahmebehälters befindet.

12. Vorrichtung zur Reinigung eines Gegenstandes nach einem der Ansprüche 8, 9, 10 und 11, dadurch gekennzeichnet, daß die nicht brennbare Flüssigkeit Wasser ist.

13. Vorrichtung zur Reinigung eines Gegenstandes nach einem der Ansprüche 8, 9, 10 oder 11, dadurch gekennzeichnet, daß die nicht brennbare Flüssigkeit Wasser ist, dem eine oberflächenaktive Substanz beigegeben ist, so daß das Lösungsmittel zur Reinigung des Gegenstandes darin löslich ist.

14. Vorrichtung zur Reinigung eines Gegenstandes nach Anspruch 8, dadurch gekennzeichnet, daß die lösungsmittelhaltige Flüssigkeit zur Reinigung des Gegenstandes ein brennbares Lösungsmittel ist.

## Revendications

1. Procédé de nettoyage d'un objet en utilisant un solvant en tant que liquide de nettoyage, caractérisé en ce que des moyens de nettoyage recevant un liquide de nettoyage sont disposés à l'intérieur d'un réservoir de réception recevant un liquide incombustible, et sont actionnés à l'intérieur du réservoir de réception.

2. Procédé de nettoyage d'un objet selon la revendication 1, caractérisé en ce que les moyens de nettoyage sont immergés dans le liquide incombustible.

3. Procédé de nettoyage d'un objet selon la revendication 1, caractérisé en ce que les moyens de nettoyage sont placés dans le réservoir de réception avec une partie de l'extrémité supérieure des moyens de nettoyage s'étendant hors du liquide incombustible de sorte qu'ils ne sont pas immergés.

4. Procédé de nettoyage d'un objet selon la revendication 1, caractérisé en ce que les moyens de nettoyage ne sont pas en contact direct avec le liquide incombustible et sont disposés au-dessus de la surface du liquide incombustible maintenu au fond du réservoir de réception.

5. Procédé de nettoyage d'un objet selon l'une quelconque des revendications 1, 2, 3 et 4, caractérisé en ce que le liquide incombustible est de l'eau.

6. Procédé de nettoyage d'un objet selon l'une quelconque des revendications 1, 2, 3 et 4, caractérisé en ce que le liquide incombustible est de l'eau avec lequel est mélangé un agent tensio-actif de sorte que le solvant destiné à nettoyer l'objet peut y être dissout.

7. Procédé de nettoyage d'un objet selon la revendication 1, caractérisé en ce que le liquide solvant pour nettoyer l'objet est un solvant combustible.

8. Appareil pour nettoyer un objet en utilisant un solvant en tant que liquide de nettoyage, caractérisé en ce que l'appareil comprend un réservoir de réception pour recevoir un liquide incombustible et des moyens de nettoyage pour nettoyer l'objet qui recoivent le liquide de nettoyage et qui sont placés à l'intérieur du réservoir de réception.

9. Appareil pour nettoyer un objet selon la revendication 8, caractérisé en ce que les moyens de nettoyage sont immergés dans le liquide incombustible.

10. Appareil pour nettoyer un objet selon la revendication 8, caractérisé en ce que les moyens de nettoyage sont placés dans le réservoir de réception avec une partie de l'extrémité supérieure des moyens de nettoyage s'étendant hors du liquide incombustible de sorte qu'ils ne sont pas immergés.

11. Appareil pour nettoyer un objet selon la revendication 8, caractérisé en ce que les moyens de nettoyage ne sont pas en contact direct avec le liquide incombustible et sont disposés au-dessus de la surface du liquide incombustible maintenu au fond du réservoir de réception.

12. Appareil pour nettoyer un objet selon l'une quelconque des revendications 8, 9, 10 et 11, caractérisé en ce que le liquide incombustible est de l'eau.

13. Appareil pour nettoyer un objet selon l'une quelconque des revendications 8, 9, 10 et 11, caractérisé en ce que le liquide incombustible est de l'eau avec lequel est mélangé un agent tensio-actif de sorte que le solvant destiné à nettoyer l'objet peut y être dissout.

14. Appareil pour nettoyer un objet selon la revendication 8, caractérisé en ce que le liquide solvant pour nettoyer l'objet est un solvant combustible.
